# EUROPÄISCHE PATENTSCHRIFT

(11) **EP 2 188 839 B1**
(45) Veröffentlichungstag und Bekanntmachung des Hinweises auf die Patenterteilung: **25.07.2018**
(21) Anmeldenummer: 08785242.2
(22) Anmeldetag: 31.07.2008
(51) Int. Cl.: H01L 25/11, H01L 25/16, H01L 23/40, H05K 1/02, H05K 1/18, H05K 7/20, H05K 3/46, H05K 3/28, H05K 3/00, H05K 1/14

(54) **VERFAHREN ZUM HERSTELLEN EINER KÜHLANORDNUNG FÜR EINE ELEKTRONISCHE SCHALTUNGSANORDNUNG MIT WÄRME ERZEUGENDEN LEISTUNGSHALBLEITERN**
FABRICATION PROCESS OF A COOLING ARRANGEMENT FOR AN ELECTRONIC CIRCUIT DEVICE COMPRISING HEAT PRODUCING POWER SEMICONDUCTORS
MÉTHODE DE FABRICATION D'UN DISPOSITIF DE REFROIDISSEMENT POUR UN CIRCUIT ÉLECTRONIQUE AVEC DES SEMICONDUCTEURS DE PUISSANCE GÉNÉRANT DE LA CHALEUR

(30) Priorität: 15.08.2007 DE 102007038676
(43) Veröffentlichungstag der Anmeldung: 26.05.2010
(73) Patentinhaber: SEW-EURODRIVE GmbH & Co. KG, 76646 Bruchsal (DE)
(72) Erfinder: POLJAK, Anton, 76299 Karlsruhe (DE)
(74) Vertreter: Tüngler, Eberhard
(86) Internationale Anmeldenummer: PCT/EP2008/006300
(87) Internationale Veröffentlichungsnummer: WO 2009/021633

(56) Entgegenhaltungen:
- WO-A-00/74446
- DE-A1- 4 231 140
- DE-A1- 10 063 944
- US-A- 5 243 218
- US-A- 5 812 375
- US-A- 5 926 369

## Beschreibung

Die Erfindung betrifft ein Verfahren zum Herstellen einer Kühlanordnung für eine elektronische Schaltungsanordnung.

Es sind Antriebe bekannt, die aus einem von einem Elektromotor angetriebenen Getriebe bestehen, wobei der Elektromotor von einem Umrichter versorgt wird.

Aus der DE 42 31 140 A1 ist eine Baugruppe für elektronische Steuergeräte bekannt.

Aus der US 5 812 375 A ist eine elektronische Anordnung mit einer selektiven Wärmeabfuhr bekannt.

Der Erfindung liegt daher die Aufgabe zugrunde, einen Antrieb weiterzubilden, wobei höhere Leistung bei gleichem Bauvolumen erreichbar sein soll, also ein kompakter leistungsstarker Antrieb herstellbar sein soll.

Erfindungsgemäß wird die Aufgabe bei dem Verfahren nach den in Anspruch 1 angegebenen Merkmalen gelöst. Bevorzugte Ausführungsformen der Erfindung sind in den abhängigen Ansprüchen erläutert. Von Vorteil ist dabei, dass mittels der flexiblen Verbindung das Leiterplattenstück unabhängig von der Leiterplatte Toleranzen ausgleichbar macht. Somit ist eine Feder verwendbar, die nur auf das mindestens eine Leiterplattenstück beziehungsweise die auf ihm bestückten Leistungshalbleiter wirkt. Die Leistungshalbleiter sind somit schwimmend gelagert an der Leiterplatte und die Leiterplatte ist somit unabhängig von den Leistungshalbleitern mit dem Gehäuse verbindbar und an ihm befestigbar.

Außerdem sind somit auf die Leistungshalbleiter wohldefinierte und hohe Druckkräfte von dem Federelement aufbringbar, wodurch ein optimal kleiner Wärmeübergangswiderstand zum Kühlkörper hin entsteht.

Das Leiterplattenstück ist auch im Randbereich der Leiterplatte positionierbar.

Bei einer vorteilhaften Ausgestaltung umfasst die elektronische Schaltung eine weitere Leiterplatte, mit der die erste Leiterplatte über einen flexiblen Bereich verbunden ist,
wobei der flexible Bereich elektrische Leiterbahnen umfasst. Von Vorteil ist dabei, dass eine mechanische Entkoppelung der Leiterplatte erreicht ist. Somit ist sie unabhängig befestigbar im Gehäuse. Außerdem fließen vorteiligerweise Starkströme von insbesondere mehr als einem Ampere über die Leiterbahnen des flexiblen Bereiches.

Bei einer vorteilhaften Ausgestaltung umfasst der flexible Bereich eine Folie, die auch zur Bildung einer Lage einer Leiterplatte vorgesehen ist. Von Vorteil ist dabei, dass schon bei der Fertigung der Leiterplatte der flexible Bereich vorgesehen ist.

Von Vorteil ist dabei, dass die Folie für ein häufiges Biegen, also häufigen Biegewechsel, und/oder hohe Temperaturbelastung und/oder Temperaturhübe dimensionierbar ist. Erfindungsgemäß ist der flexible Bereich durch Ausfräsen aus einer Leiterplatte hergestellt. Von Vorteil ist dabei, dass aus dem Ausgangsmaterial einer Multilayer-Leiterplatte in einfacher Weise der flexible Bereich herausarbeitbar ist.

Bei einer vorteilhaften Ausgestaltung sind die elektrischen Leiterbahnen des flexiblen Bereichs als Leiterbahnen aus Kupfer oder aus einem zumindest Kupfer auch umfassenden Stoffgemisches ausgeführt, insbesondere wobei diese Bahnen vergoldet, vernickelt und/oder verzinnt sind. Von Vorteil ist dabei, dass ein Korrosionsschutz vorsehbar ist.

Bei einer vorteilhaften Ausgestaltung ist das Federelement zwischen Leiterplattenstück mit Leistungshalbleiter und einem Gehäuseteil angeordnet oder zwischen einem mit einem Gehäuseteil verbundenen Teil und dem Leiterplattenstück mit Leistungshalbleiter. Von Vorteil ist dabei, dass die Feder sich abstützen darf am Gehäuse und somit wohldefinierbare hohe Kräfte zum Anpressen der Leistungshalbleiter an den Kühlkörper erzeugbar sind. Der Kühlkörper ist vorteiligerweise mit dem Gehäuse fest verbunden.

Bei einer vorteilhaften Ausgestaltung sind Leistungshalbleiter als SMD-Bauteil bestückt auf dem Leiterplattenstück. Von Vorteil ist dabei, dass eine besonders einfache und automatisiert ausführbare Fertigungsmethode anwendbar ist. Insbesondere sind die Leistungshalbleiter in derselben Aufspannung und Maschine bestückbar wie auch die anderen Bauelemente, insbesondere auch der Signalelektronik. Erfindungsgemäß sind die erste Leiterplatte und das Leiterplattenstück verbindende Stege vorgesehen, insbesondere mit entsprechenden Bruchstellen versehen, die nach Bestückung herausgebrochen werden. Von Vorteil ist dabei, dass während der SMD Bestückung noch eine hohe mechanische Stabilität vorhanden ist und somit die Bestückung der Leistungshalbleiter zusammen mit den anderen Bauelementen in derselben Weise erfolgen darf. Nach dem Herausbrechen ist eine mechanische Entkopplung erreicht, wobei die Toleranzen bei der Befestigung der Leiterplatte und der Leistungshalbleiter beziehungsweise ihrer Leiterplattenstücke unterschiedlich sein dürfen. In einer erfinderischen Alternative ist jedem Leistungshalbleiter ein jeweiliges Leiterplattenstück zugeordnet. Von Vorteil ist dabei, dass jeder Leistungshalbleiter vollständig entkoppelt ist und somit die Feder genau auf das Anpressen des jeweiligen Leiterplattenstücks beziehungsweise Leistungshalbleiters auslegbar ist.

Bei einer vorteilhaften Ausgestaltung ist jeder Leistungshalbleiter und/oder sein Leiterplattenstück von einem jeweiligen oder gemeinsamen Federelement an den Kühlkörper gedrückt vorgesehen. Von Vorteil ist dabei, dass ein individuell angepasstes Anpressen oder ein einfaches kostengünstiges Anpressen anwendbar ist.

Bei einer vorteilhaften Ausgestaltung ist mindestens die erste Leiterplatte oder die erste und eine weitere Leiterplatte mit Vergussmasse, die zumindest vom Kühlkörper begrenzt ist, umgossen. Von Vorteil ist dabei, dass eine Wärmeableitung der Wärme von Bauelementen der Leistungselektronik und/oder Signalelektronik an den Kühlkörper erreichbar ist. Somit sind Leistungselektronik und Signalelektronik im Wesentlichen auf einem Temperaturniveau. Aber nicht nur die Aufspreizung der Wärme ist von Vorteil sondern auch die Schutzfunktion gegen Feuchtigkeit sowie die Unterdrückung von Schwingungen. Somit werden die Bauelemente von der Vergussmasse geschützt vor Feuchtigkeit und mechanisch stabiler gehalten.

Bei einer Ausgestaltung, die nicht zur vorliegenden Erfindung gehört, ist der flexible Bereich als Flachbandkabel und/oder elektrisches Kabel ausgeführt. Von Vorteil ist dabei, dass auch andere kostengünstige Entkoppelungsmöglichkeiten realisierbar sind. Allerdings ist die Fertigung hiervon aufwendiger als bei den flexiblen Bereichen.

Bei einer vorteilhaften Ausgestaltung ist die weitere Leiterplatte derart gedreht und/oder gefaltet angeordnet, dass sie über den flexiblen Bereich mit der ersten Leiterplatte verbunden ist und an der vom Kühlkörper abgewandten Seite der ersten Leiterplatte vorgesehen ist. Von Vorteil ist dabei, dass ein kompakter Aufbau erreichbar ist.

Bei einer vorteilhaften Ausgestaltung ist der Kühlkörper als Schale zur Aufnahme der Vergussmasse ausgeformt oder der Kühlkörper ist mit Teilen derart dicht verbunden, dass eine Schale zur Aufnahme der Vergussmasse ausgeformt ist. Von Vorteil ist dabei, dass kein zusätzliches Schalenteil notwendig ist und somit ein direkter Wärmeübergang ermöglicht ist.

Bei einer vorteilhaften Ausgestaltung ist neben dem jeweiligen Leistungshalbleiter auf dem Leiterplattenstück auch die Ansteuerelektronik für den jeweiligen Leistungshalbleiter angeordnet, insbesondere umfassend eine Treiberschaltung. Von Vorteil ist dabei, dass zwischen erster Leiterplatte und Leiterplattenstück eine geringe Anzahl elektrischer Verbindungen, also Leiterbahnen, auszuführen ist. Das erfindungsgemäße Verfahren findet Anwendung auf dem Gebiet der Antriebe. Wichtige Merkmale bei dem Antrieb sind, dass er ein als Umrichter ausgeführtes Elektrogerät umfasst und mindestens eine weitere Antriebskomponente, insbesondere Elektromotor, Getriebe, Kupplung, Bremse oder dergleichen, umfasst, wobei der Kühlkörper über eine Wärmesperre mit dem Gehäuse einer weiteren Antriebskomponente, insbesondere Motor, Getriebe, Kupplung oder Bremse, verbunden ist. Von Vorteil ist dabei, dass die Temperaturniveaus des Gehäuseteils für die Elektronik unterschiedlich vorsehbar ist zum Niveau des Gehäuseteils des Elektromotors und/oder Getriebes.

Die Erfindung wird nun anhand von Abbildungen näher erläutert:
In der Figur 1 ist eine Leiterplattenanordnung einer erfindungsgemäßen Vorrichtung in Draufsicht skizziert.

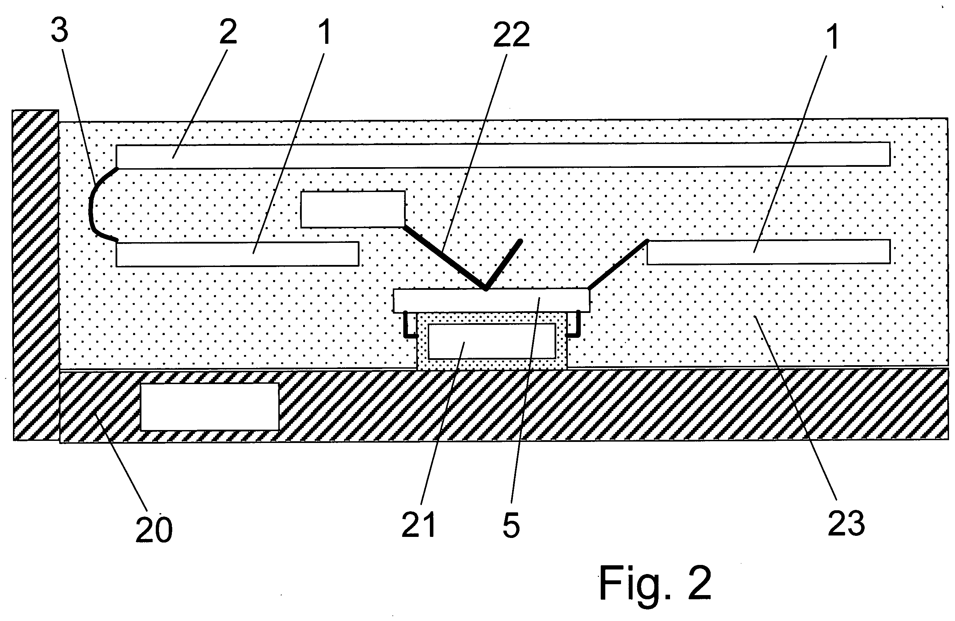

In der Figur 2 ist eine Schnittansicht skizziert.

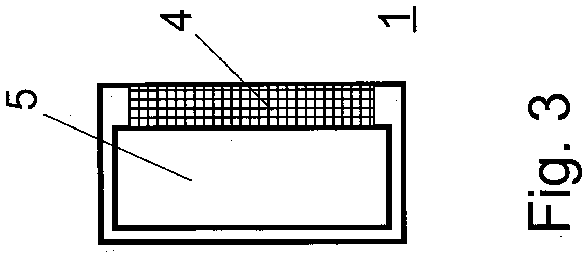

In der Figur 3 ist ein Teilausschnitt der Figur 2 gezeigt.
In der Figur 4 ist ein der Figur 3 entsprechender Ausschnitt eines erfindungsgemäßen anderen Ausführungsbeispiels gezeigt.

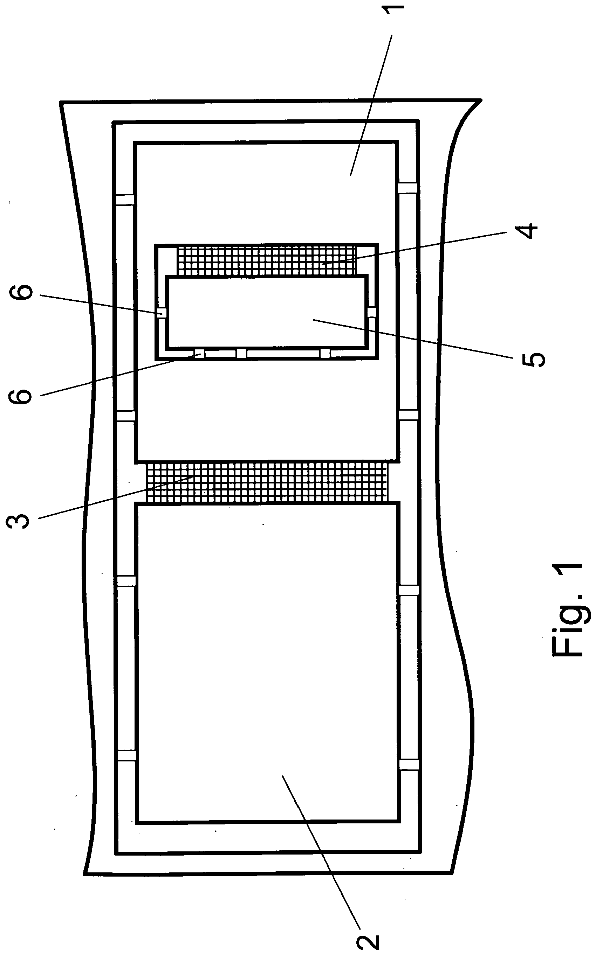

In der Figur 1 sind die Stege 6 noch nicht herausgebrochen

In der Figur 1 ist eine Leiterplatte 1 für Leistungselektronik vorgesehen. Dabei weist die Leistungselektronik eines einen Elektromotor versorgenden Umrichters zumindest Gleichrichterdioden und Zwischenkreiskondensator auf. Die Leistungshalbleiter 21 sind auf einem Leiterplattenstück 5 für Leistungshalbleiter vorgesehen. Bei der Fertigung der Leiterplatte ist dieses Leiterplattenstück noch über belassene Stege 6 mit der Leiterplatte 1 verbunden. Außerdem ist ein flexibler Bereich 4 vorgesehen, der mechanisch flexible, elastisch verformbare elektrische Verbindungen zwischen dem Leiterplattenstück 5 und der Leiterplatte 1 ermöglicht.

Auch von der Leiterplatte 1 zur Leiterplatte 2, welche für Steuerelektronik vorgesehen ist, ist ein solcher flexibler Bereich 4 vorhanden. Somit ist die Leiterplatte 2 von oben her auf die Leiterplatte 1 faltbar und somit eine räumlich kompakte Anordnung erreichbar.

Nach der Bestückung, insbesondere vorzugsweise mit SMD Technik, werden die Stege 6 herausgebrochen.

Dann ist das Leiterplattenstück 5 unabhängig von der Leiterplatte 1 - zumindest bei kleinen Verschiebungen.

Die auf dem Leiterplattenstück 5 vorgesehenen Leistungshalbleiter 21 werden mittels Federkraft eines am Gehäuseteil oder einem mit dem Gehäuse verbundenen Teils abgestützten Federelements 22 gegen den Kühlkörper 20 gedrückt. Im Berührbereich ist die Oberfläche des Kühlkörpers hierzu bearbeitet, insbesondere plan bearbeitet und/oder sandgestrahlt. Zwischen Kühlkörper 20 und Leistungshalbleiter 21 wird auch Wärmeleitpaste zur weiteren Verbesserung des Wärmeübergangs vorgesehen.

Die Leiterplatte 1 und die Leiterplatte 2 sind insgesamt mit Vergussmasse 23 umgossen zur Verbesserung der Wärmeabfuhr von den einzelnen Bauelementen an den Kühlkörper. Außerdem weist die Vergussmasse isolierende Eigenschaften auf und verbessert die mechanische Stabilität.

Die flexiblen Bereiche 3 und 4 sind aus einer Multilayer-Leiterplatte hergestellt. Dabei weist die Mulitlayer-Leiterplatte zwei oder mehr Lagen auf, die in isolierendem Leiterplattenmaterial sozusagen eingebettet vorgesehen sind. Die Multilayer-Leiterplatte ist derart groß, dass aus ihr die Leiterplatte 1 und 2 sowie die flexiblen Bereich herstellbar sind. Zur Herstellung der flexiblen Bereich wird ein Präzisionsfräsen ausgeführt und eine der Lagen frei gelegt und belassen. Die Lage umfasst hierbei eine Folie, auf der Kupfer-Leiterbahnen, insbesondere vergoldet, verzinnt und/oder vernickelt, vorgesehen sind. Nach dem Fräsvorgang wird ein Lack, insbesondere ein Lötstopp-Lack aufgetragen. Somit sind die Leiterplatte 1 und 2 sowie die flexiblen Bereiche aus einer einzigen Multilayer-Leiterplatte herstellbar.

Außerdem werden die um das Leiterplattenstück 5 vorhandenen Bereiche entfernt mit Ausnahme der Stege 6.

Nach der SMD Bestückung, mit der auch die Leitungshalbleiter bestückt sind, werden die Stege herausgebrochen und es wird somit eine gewisse Entkoppelung der Leistungshalbleiter von der Leiterplatte 1 erreicht. Dadurch ist es ermöglicht, das Federelement zum Anpressen der Leistungshalbleiter an den Kühlkörper anzubringen und separat auf diese wirken zu lassen.

Dabei weist also der flexible Bereich die gleichen Folien wie die anderen Lagen der Multilayer-Leiterplatte auf. Bei einer Variante, die nicht zur vorliegenden Erfindung gehört, werden die flexiblen Bereiche schon bei der Herstellung der Multilayer-Leiterplatte eingebracht. Hierbei werden also nacheinander die anderen Lagen vorgesehen und bei Einbringen derjenigen Lage, die die flexiblen Bereiche Herstellen soll, eine speziell dimensionierte Folie mit Kupferbahnen vorgesehen. Ein Ausfräsen ist bei dieser Fertigungsmethode nicht notwendig, weil Leiterplatte 1 und 2 nur aufgebaut werden müssen und im Bereich der flexiblen Bereiche kein isolierendes Material und auch keine anderen Lagen vorgesehen werden müssen. Die spezielle Folie ist derart dimensionierbar, dass viele Biegezyklen ausführbar sind, also eine hohe Standzeit erreichbar ist.

Aber auch in dieser Variante ist die Folie der flexiblen Bereiche durchgängig und somit auch in einer der Lagen der Leiterplatten 1 und 2 vorhanden. Bei einer anderen Variante, die nicht zur vorliegenden Erfindung gehört, werden die flexiblen Bereiche mittels Flachbandkabel und/oder elektrischer Kabel, die jeweils steckverbunden oder lötverbunden sind mit Kontaktbereichen oder -elementen der Leiterplatte 1 und des Leiterplattenstücks 5.

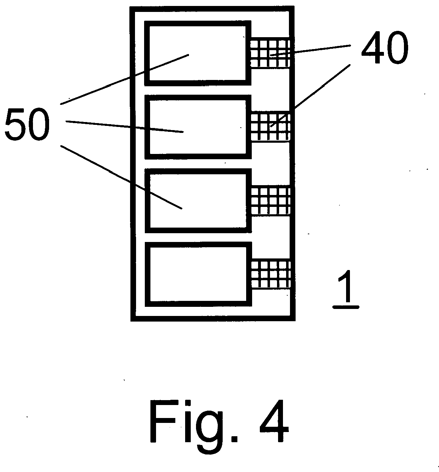

In Figur 4 ist im Gegensatz zur Figur 1 ein anderes erfindungsgemäßes Ausführungsbeispiel gezeigt, bei dem die Leistungshalbleiter jeweils einzeln auf einem Leiterplattenstück vorgesehen sind, die jeweils über flexible Bereiche mit der Leiterplatte 1 verbunden sind. Die hierbei während der SMD Fertigung vorhandenen Stege werden wiederum herausgebrochen und somit jeder Leistungshalbleiter einzeln bewegbar angeordnet. Auf diese Weise ist nun jeder Leistungshalbleiter mittels einem einzelnen ihm zugeordneten Federelement andrückbar an den Kühlkörper 20. Es ist aber auch eine gemeinsame Feder verwendbar, vorzugsweise eine Blattfeder.

Die auf den Leiterplatten 1 und 2 vorgesehene elektronische Schaltung ist vorzugsweise als Umrichterelektronik eines Antriebs, der auch einen von diesem Umrichter gespeisten Elektromotor und ein von diesem angetriebenes Getriebe aufweist. Dieser Antrieb ist vorzugsweise in einem einzigen Gehäuse als kompakter Antrieb realisiert. Somit ist auch der Kühlkörper ein Teil des Gehäuses und mit weiteren Gehäuseteilen verbunden. Die Entwärmung des Motors und des Getriebes erfolgt über diese weiteren Gehäuseteile. Vorzugsweise ist eine Wärmesperre zum Kühlkörper und auch zur Umrichterelektronik vorgesehen.

Eine besonders einfache Wartung ist dann erreichbar, wenn die Umrichterelektronik in einem als Gehäusedeckelteil ausgeführten Kühlkörper 20 mittels Vergussmasse verbunden wird und somit bei Wartung oder Reparatur nur der Deckel gegen einen neuen auszutauschen ist.

### Bezugszeichenliste

1 Leiterplatte für Leistungselektronik
2 Leiterplatte für Steuerelektronik
3 flexibler Bereich
4 flexibler Bereich
5 Leiterplattenstück für Leistungshalbleiter
6 Stege
20 Kühlkörper
21 Leistungshalbleiter
22 Federelement
23 Vergussmasse
40 flexibler Bereich
50 Leiterpiattenstück

## Patentansprüche

1. Verfahren zum Herstellen einer Kühlanordnung für eine elektronische Schaltungsanordnung mit Wärme erzeugenden Leistungshalbleitern (21), die mittels mindestens eines Federelements (22) an einen Kühlkörper (20) angedrückt sind, wobei das Verfahren folgende Verfahrensschritte in dieser Reihenfolge beinhaltet:
a) Bereitstellung einer Multilayer-Leiterplatte (1) der elektronischen Schaltungsanordnung;
b) Bearbeitung der Leiterplatte
- Entfernen von Leiterplattenbereichen um mindestens ein Leiterplattenstück (5) herum und Bildung von Stegen (6), die eine Portion der Leiterplatte und das mindestens eine Leiterplattenstück verbinden; und
- Bildung eines flexiblen Verbindungsbereiches (4) zwischen dem mindestens einem Leiterplattenstück und einer Portion der Leiterplatte durch Ausfräsen eines Bereichs der Leiterplatte, das zur Freilegung einer Folie der Leiterplatte führt, auf der elektrische Leiterbahnen vorgesehen sind, welche das mindestens eine Leiterplattenstück und eine Portion der Leiterplatte, die sich um die Stege, den Verbindungsbereich und das mindestens eine Leiterplattenstück herum befindet, elektrisch verbinden;
c1) Bestückung des Leiterplattenstücks mit Leistungshalbleitern, falls im Schritt b) nur ein Leiterplattenstück entsteht, oder
c2) Bestückung von jedem Leiterplattenstück mit einem Leistungshalbleiter, falls im Schritt b) eine Mehrzahl von Leiterplattenstücken entsteht
d) Herausbrechen der Stege;
e) Bereitstellung eines Kühlkörpers und mindestens eines Federelements, wobei der Kühlkörper und das mindestens eine Federelement so angeordnet werden, dass das mindestens eine Leiterplattenstück mittels des mindestens einen Federelements angedrückt wird, wobei die Leistungshalbleiter an den Kühlkörper angedrückt werden

2. Verfahren nach Anspruch 1,
wobei die Leiterplatte eine erste Leiterplatte ist; und
wobei die elektronische Schaltungsanordnung eine weitere Leiterplatte (2) aufweist, mit der die erste Leiterplatte (1) über einen weiteren flexiblen Verbindungsbereich (3) verbunden ist, wobei der weitere flexible Verbindungsbereich (3) elektrische Leiterbahnen aufweist.

3. Verfahren nach einem der vorangehenden Ansprüche,
**dadurch gekennzeichnet, dass**
die elektrischen Leiterbahnen des flexiblen und/oder des weiteren flexiblen Verbindungsbereichs (3, 4) als Leiterbahnen aus Kupfer oder aus einem zumindest Kupfer auch aufweisenden Stoffgemisches ausgeführt werden.

4. Verfahren nach Anspruch 3,
**dadurch gekennzeichnet, dass**
diese Leiterbahnen vergoldet, vernickelt und/oder verzinnt werden.

5. Verfahren nach einem der vorangehenden Ansprüche,
**dadurch gekennzeichnet, dass**
das Federelement (22) zwischen dem mindestens einen Leiterplattenstück (5) und einem Gehäuseteil angeordnet wird oder zwischen einem mit einem Gehäuseteil verbundenen Teil und dem mindestens einen Leiterplattenstück (5).

6. Verfahren nach einem der vorangehenden Ansprüche,
**dadurch gekennzeichnet, dass**
die Leistungshalbleiter (21) als SMD-Bauteile ausgeführt sind.

7. Verfahren nach einem der Ansprüche 2 bis 6,
**dadurch gekennzeichnet, dass**
mindestens die erste Leiterplatte oder die erste und weitere Leiterplatte mit Vergussmasse, die zumindest vom Kühlkörper (20) begrenzt ist, umgossen wird zur Wärmeableitung der Wärme von den Leistungshableitern und/oder der Ansteuerelektronik für die Leistungshalbleiter an den Kühlkörper (20).

8. Verfahren nach einem der Ansprüche 2 bis 7,
**dadurch gekennzeichnet, dass**
die weitere Leiterplatte (2) an die vom Kühlkörper (20) abgewandten Seite der ersten Leiterplatte vorgesehen ist.

9. Verfahren nach Anspruch 7,
**dadurch gekennzeichnet, dass**
der Kühlkörper (20) als Schale zur Aufnahme der Vergussmasse (23) ausgeformt ist oder dass eine aus dem Kühlkörper (20) und mit diesem dicht verbundenen Teilen gebildete Schale zur Aufnahme der Vergussmasse (23) ausgeformt ist.

10. Verfahren nach einem der vorangehenden Ansprüche,
**dadurch gekennzeichnet, dass**
neben dem jeweiligen Leistungshalbleiter (21) auf dem mindestens einen Leiterplattenstück (5) auch die Ansteuerelektronik für den jeweiligen Leistungshalbleiter (21) angeordnet wird.

## Claims

1. Method for producing a cooling arrangement for an electronic circuit arrangement comprising heat-generating power semiconductors (21) which are pressed against a cooling body (20) by means of at least one spring element (22), the method containing the following method steps in this order:
a) providing a multilayer printed circuit board (1) of the electronic circuit arrangement;
b) machining the printed circuit board
- removing printed circuit board regions around at least one printed circuit board piece (5) and forming webs (6) which connect a portion of the printed circuit board and the at least one printed circuit board piece; and
- forming a flexible connecting region (4) between the at least one printed circuit board piece and a portion of the printed circuit board by milling out a region of the printed circuit board, leading to the exposure of a film of the printed circuit board on which electrical conductor tracks are provided, which electrical conductor tracks electrically connect the at least one printed circuit board piece and a portion of the printed circuit board located around the webs, the connecting region and the at least one printed circuit board piece;
c1) equipping the printed circuit board piece with power semiconductors if only one printed circuit board piece is created in step b), or
c2) equipping each printed circuit board piece with a power semiconductor if a plurality of printed circuit board pieces are created in step b);
d) breaking out the webs;
e) providing a cooling body and at least one spring element, the cooling body and the at least one spring element being arranged in such a way that the at least one printed circuit board piece is pressed by means of the at least one spring element, the power semiconductors being pressed against the cooling body.

2. Method according to claim 1,
wherein the printed circuit board is a first printed circuit board; and
wherein the electronic circuit arrangement has a further printed circuit board (2), to which the first printed circuit board (1) is connected via a further flexible connecting region (3), the further flexible connecting region (3) having electrical conductor tracks.

3. Method according to one of the preceding claims, **characterized in that** the electrical conductor tracks of the flexible and/or further flexible connecting region (3, 4) are embodied as conductor tracks made of copper or made of a substance mixture which contains at least copper.

4. Method according to claim 3, **characterized in that** said conductor tracks are plated with gold, nickel and/or tin.

5. Method according to one of the preceding claims, **characterized in that** the spring element (22) is arranged between the at least one printed circuit board piece (5) and a housing part or between a part connected to the housing part and the at least one printed circuit board piece (5).

6. Method according to one of the preceding claims, **characterized in that** the power semiconductors (21) are embodied as SMD components.

7. Method according to one of claims 2 to 6, **characterized in that** at least the first printed circuit board or the first and further printed circuit board has potting compound cast around it, in a manner delimited at least by the cooling body (20), in order to dissipate the heat from the power semiconductors and/or from the control electronics for the power semiconductors to the cooling body (20).

8. Method according to one of claims 2 to 7, **characterized in that** the further printed circuit board (2) is provided on the side of the first printed circuit board that is remote from the cooling body (20).

9. Method according to claim 7, **characterized in that** the cooling body (20) is shaped as a shell to accommodate the potting compound (23), or **in that** a shell formed from the cooling body (20) and parts tightly connected to the latter is shaped to accommodate the potting compound (23).

10. Method according to one of the preceding claims, **characterized in that**, besides the respective power semiconductor (21), the control electronics for the respective power semiconductor (21) are also arranged on the at least one printed circuit board piece (5).

## Revendications

1. Procédé de fabrication d'un dispositif de refroidissement pour un ensemble circuit électronique équipé de semi-conducteurs de puissance générant de la chaleur (21) qui sont pressés contre un dissipateur thermique (20) au moyen d'au moins un élément élastique (22), le procédé comprenant les étapes suivantes dans cet ordre :
a) fourniture d'une carte de circuit imprimé multicouche (1) de l'ensemble circuit électronique ;
b) traitement de la carte de circuit imprimé :
- enlèvement de zones de carte de circuit imprimé autour d'au moins une pièce de carte de circuit imprimé (5) et formation de ponts (6) qui relient une partie de la carte de circuit imprimé et ladite au moins une pièce de carte de circuit imprimé ; et
- formation d'une zone de liaison flexible (4) entre ladite au moins une pièce de carte de circuit imprimé et une partie de la carte de circuit imprimé par fraisage d'une zone de la carte de circuit imprimé, qui conduit à l'exposition d'un film de la carte de circuit imprimé sur lequel sont prévues des pistes conductrices électriques qui relient électriquement ladite au moins une pièce de carte de circuit imprimé et une partie de la carte de circuit imprimé qui se trouve autour des ponts, de la zone de liaison et de ladite au moins une pièce de carte de circuit imprimé ;
c1) équipement de la pièce de carte de circuit imprimé avec des semi-conducteurs de puissance si, à l'étape b), une seule pièce de carte de circuit imprimé est formée, ou
c2) équipement de chaque pièce de carte de circuit imprimé avec un semi-conducteur de puissance si, à l'étape b), une pluralité de pièces de carte de circuit imprimé est formée ;
d) rupture des ponts ;
e) fourniture d'un dissipateur thermique et d'au moins un élément élastique, le dissipateur thermique et ledit au moins un élément élastique étant disposés de telle sorte que ladite au moins une pièce de carte de circuit imprimé est pressée au moyen dudit au moins un élément élastique, les semi-conducteurs de puissance étant pressés contre le dissipateur thermique.

2. Procédé selon la revendication 1,
dans lequel la carte de circuit imprimé est une première carte de circuit imprimé ; et dans lequel l'ensemble circuit électronique présente une autre carte de circuit imprimé (2) à laquelle la première carte de circuit imprimé (1) est reliée par l'intermédiaire d'une autre zone de liaison flexible (3),
dans lequel l'autre zone de liaison flexible (3) présente des pistes conductrices électriques.

3. Procédé selon l'une des revendications précédentes,
**caractérisé en ce que**
les pistes conductrices électriques de la zone de liaison flexible (4) et/ou de l'autre zone de liaison flexible (3) sont réalisées sous la forme de pistes conductrices en cuivre ou en un mélange de substances présentant également au moins du cuivre.

4. Procédé selon la revendication 3,
**caractérisé en ce que**
ces pistes conductrices sont dorées, nickelées et/ou étamées.

5. Procédé selon l'une des revendications précédentes,
**caractérisé en ce que**
l'élément élastique (22) est disposé entre ladite au moins une pièce de carte de circuit imprimé (5) et une partie de boîtier ou entre une partie reliée à une partie de boîtier et ladite au moins une pièce de carte de circuit imprimé (5).

6. Procédé selon l'une des revendications précédentes,
**caractérisé en ce que**
les semi-conducteurs de puissance (21) sont réalisés sous la forme de composants SMD.

7. Procédé selon l'une des revendications 2 à 6,
**caractérisé en ce que**
au moins la première carte de circuit imprimé ou la première et l'autre carte de circuit sont enrobées d'une masse de scellement qui est limitée au moins par le dissipateur thermique (20) pour dissiper la chaleur des semi-conducteurs de puissance et/ou de l'électronique de commande des semi-conducteurs de puissance sur le dissipateur thermique (20).

8. Procédé selon l'une des revendications 2 à 7,
**caractérisé en ce que**
l'autre carte de circuit imprimé (2) est prévue sur le côté de la première carte de circuit imprimé opposé au dissipateur thermique (20).

9. Procédé selon la revendication 7,
**caractérisé en ce que**
le dissipateur thermique (20) est formé comme une coque destinée à recevoir la masse de scellement (23) ou qu'une coque formée du dissipateur thermique (20) et de parties reliées à celui-ci de manière étanche, destinée à recevoir la masse de scellement (23), est formée.

10. Procédé selon l'une des revendications précédentes,
**caractérisé en ce que**
en plus du semi-conducteur de puissance respectif (21), l'électronique de commande du semi-conducteur de puissance respectif (21) est disposée sur ladite au moins une pièce de carte de circuit imprimé (5).
